# EUROPÄISCHE PATENTANMELDUNG

(11) **EP 4 368 972 A1**
(43) Veröffentlichungstag der Anmeldung: **15.05.2024**
(21) Anmeldenummer: 23206394.1
(22) Anmeldetag: 27.10.2023
(51) Int. Cl.: G01N 21/88, G01N 21/956, G01N 21/95, G01B 11/25, H01L 21/67, H05K 13/08

(54) **VORRICHTUNG UND VERFAHREN ZUM PRÜFEN ZWEI- ODER DREIDIMENSIONALER OBJEKTE**

(30) Priorität: 08.11.2022 DE 102022129464
(71) Anmelder: Göpel electronic GmbH, 07745 Jena (DE)
(72) Erfinder: Schambach, Dr. Jörg, 07639 Bad Klosterlausnitz (DE); Richter, Johannes, 07749 Jena (DE); Zimmermann, Manuel, 07937 Zeulenroda-Triebes (DE)
(74) Vertreter: Gleim Petri Patent- und Rechtsanwaltspartnerschaft mbB

(57) **Zusammenfassung**

Die Erfindung betrifft eine Vorrichtung sowie ein Verfahren zur AOI-Prüfung von zwei- oder dreidimensionalen Objekten (1) mit unterschiedlichen Bereichen (Bi) von zu prüfenden Bauelementen (11) oder Baugruppen (12). Die Vorrichtung umfasst eine Kameraanordnung (2) mit mindestens einer ersten Kamera (211) mit einer ersten Auflösung und mindestens einer zweiten Kamera (212) mit einer zweiten Auflösung, wobei die Kameras (21) dazu ausgebildet sind, Bereiche (Bi) des zu prüfenden Objekts (1) in jeweils einem unterschiedlichen Bildfeld abzubilden, und eine Auswerte- und Speichereinheit (3), die mit den Kameras (21) verbunden und dazu ausgebildet ist, von den Kameras (21) aufgenommene Abbildungen zu speichern und auszuwerten und so eingerichtet ist, um eine Prüffunktion auf die Abbildungen von abgetasteten Bereichen (Bi) der Gesamtfläche (A) des Objekts (1) anzuwenden, wobei ein Soll-Ist-Vergleich aller zu prüfenden Eigenschaften von Bauelementen (11) oder Baugruppen (12) des Objekts (1) vorhanden ist, sodass fehlende oder fehlerhafte Bauelemente (11) oder Baugruppen (12) des Objekts (1) erkannt werden.

## Beschreibung

Die Erfindung betrifft eine Vorrichtung sowie ein Verfahren zur Prüfung von zwei- oder dreidimensionalen Objekten mit unterschiedlichen Bereichen von zu prüfenden Bauelementen oder Baugruppen, insbesondere von Leiterplatten, Wafern oder Chips.

Bildaufnahmesysteme für die Prüfung von zwei- oder dreidimensionalen Objekten durch automatische optische Inspektion (AOI) benötigen eine sehr gute Auflösung, um auch kleinste Details erfassen zu können. Derartige Bildaufnahmesysteme müssen die zu inspizierenden Objekte zudem sehr schnell im Linientakt prüfen, um wirtschaftlich betrieben werden zu können.

Kameras mit über 100 Megapixeln sind kommerziell verfügbar. Moderne Kamerainterfaces, wie z.B. Coax Press, ermöglichen die Übertragung von mehr als 31 Bildern pro Sekunde bei einer Kamera mit 100 Megapixeln.

Obwohl der Markt immer höhere Auflösungen und immer höhere Bildübertragungsraten zu bieten hat, gibt es einige limitierende Faktoren, die die Einsatzmöglichkeiten solcher Kameras in AOI-Systemen einschränken. Dazu zählen vor allem die hohen Anschaffungskosten solcher Kameras. Zudem werden üblicherweise telezentrische Objektive eingesetzt, um große Bildfelder der Kameras und geringe Bildverzerrung zu gewährleisten. Jedoch sind Bauraum und Masse des telezentrischen Objektivs ebenfalls sehr groß, da die objektseitige Linse einer telezentrischen Optik einen Durchmesser besitzt, der mindestens so groß wie die Diagonale des abzubildenden Bildfeldes ist.

Aus dem Stand der Technik sind verschiedenste Vorrichtungen sowie Verfahren zum Messen und/oder Prüfen von zwei- oder dreidimensionaler Objekte bekannt.

Eine Inspektionsvorrichtung zur Inspektion von flachen Objekten, insbesondere Wafern, ist aus der DE 10 2012 111 835 A1 bekannt. Die Inspektionsvorrichtung enthält eine Kameraanordnung mit mindestens zwei Kameras, die jeweils zur Aufnahme eines Bildes zumindest eines Teiles des Objekts geeignet sind. Dabei sind die von unterschiedlichen Kameras abgebildeten Objektbereiche zumindest teilweise unterschiedlich, wobei alle Kameras gemeinsam nur einen Teil des gesamten Inspektionsbereichs des Objekts gleichzeitig erfassen. Durch eine mit einer Antriebsanordnung erzeugte Relativbewegung zwischen Kameraanordnung und Objekt ist jeder Objektpunkt des gesamten Inspektionsbereichs zumindest einmal in eine der Kameras abbildbar.

Aus der EP 3 628 995 A1 ist eine Kalibriervorlage sowie ein Kalibrierverfahren zum Kalibrieren eines Kamerasystems bekannt. Das Kamerasystem dient zum automatischen Prüfen von Objekten und weist eine Vielzahl von Kameras mit entozentrischen Objektiven auf.

Die DE 20 2008 004 430 U1 offenbart eine Prüfvorrichtung zum optischen Prüfen von Prüfobjekten, die eine Abbildungseinrichtung zum Abbilden von Bildern eines Prüfbereiches enthält. Die Abbildungseinrichtung weist eine Mehrzahl von Kameras auf, die in einem Array relativ zueinander fixiert angeordnet und einem vorgegebenen Prüfbereich derart zugeordnet sind, dass die Bildfelder der Kameras zusammen den Prüfbereich abdecken. Das von jeder einzelnen Kamera erfasste Bildfeld ist dabei jeweils kleiner als der Prüfbereich und dient vornehmlich dazu, durch die Vermeidung von Kamerascans die Prüfzeit zu verkürzen.

Ein wesentlicher Nachteil der genannten Lösungen ist es, dass die Kameras sich nicht voneinander unterscheiden und jeweils unflexibel einer vorgegebenen Teilfläche des Prüfbereichs zugeordnet sind. Somit ist bei der Abtastung der zu prüfenden Objekte keine Flexibilität bei der optischen Auflösung der Abbildung einzelner Bereiche gegeben. Wenn bei der Abtastung der zu prüfenden Bereiche eine hohe Auflösung notwendig ist, werden viele teure Kameras zur Abbildung benötigt oder die Abtastung muss in einem Scanregime erfolgen und ist dann sehr zeitintensiv.

Es ist die Aufgabe der Erfindung, eine neuartige Möglichkeit zum Prüfen zwei- oder dreidimensionaler Objekte mittels optischer Abtastung zu finden, mit der bei der optischen Abbildung die Auflösung der Objekte für Bereiche mit unterschiedlichen zu prüfenden Baugruppen je nach Bedarf erhöht werden kann, ohne dass sich Abtastzeiten (Durchsatz) und Kosten drastisch erhöhen. Ferner soll ein Verfahren zum Prüfen zwei- oder dreidimensionaler Objekte mittels zeitoptimierter optischer Abtastung bei flexibler Auflösung für Bereiche mit unterschiedlichen zu prüfenden Baugruppen bereitgestellt werden.

Die Aufgabe wird für eine Vorrichtung zur AOI-Prüfung von zwei- oder dreidimensionalen Objekten mit unterschiedlichen Bereichen von zu prüfenden Bauelementen oder Baugruppen, insbesondere von Leiterplatten, Wafern oder Chips, umfassend eine Kameraanordnung mit mehreren Kameras, wobei die Kameras so angeordnet sind, dass optische Achsen der Kameras parallel zueinander verlaufen und die Kameras dazu ausgebildet sind, Bereiche des zu prüfenden Objekts in jeweils einem unterschiedlichen Bildfeld abzubilden, wobei das Bildfeld jeder der Kameras kleiner als eine abzutastende Gesamtfläche des Objekts ist, und eine Auswerte- und Speichereinheit, die mit den Kameras verbunden und dazu ausgebildet ist, von den Kameras aufgenommene Abbildungen zu speichern und auszuwerten, dadurch gelöst, dass die Kameras als entozentrische Kameras ausgebildet sind, und die Kameraanordnung mindestens eine erste Kamera mit einer ersten Auflösung und mindestens eine zweite Kamera mit einer zweiten, von der ersten verschiedenen Auflösung aufweist, wobei die mindestens eine erste Kamera und die mindestens eine zweite Kamera gleich große Bildfelder und zueinander parallel ausgerichtete erste optische Achsen aufweisen, und die Auswerte- und Speichereinheit so eingerichtet ist, um eine Prüffunktion auf die Abbildungen von abgetasteten Bereichen der Gesamtfläche des Objekts anzuwenden, wobei ein Soll-Ist-Vergleich aller zu prüfenden Eigenschaften von Bauelementen oder Baugruppen des Objekts vorhanden ist, sodass fehlende oder fehlerhafte Bauelemente oder Baugruppen des Objekts erkannt werden.

Dadurch, dass die Kameraeinrichtung Kameras mit unterschiedlichen Auflösungen aufweist, kann bei der optischen Abbildung unterschiedlicher zu prüfender Bauelemente und Baugruppen die Auflösung für unterschiedliche Bereiche flexibel variiert werden, ohne längere Abtastzeiten zu erfordern. Außerdem können dadurch, dass Kameras höhere Auflösung nur für Bereiche des Objekts, die Abbildungen in höherer Auflösung erfordern, verwendet werden, kann eine erforderliche Anzahl der Kameras höherer Auflösung verringert werden und die Kosten der Vorrichtung erheblich gesenkt werden.

Als Bildfeld einer Kamera wird ein Bereich in einer Objektebene, in der das Objekt angeordnet ist, verstanden, der durch die Kamera abgebildet werden kann. Das Bildfeld der Kamera ändert sich mit der Positionierung und der Ausrichtung der Kamera relativ zu dem Objekt. Die Bildfelder der Kameras können sich überlappen. Das hat den Vorteil, dass bei einer Auswertung der Abbildungen der abgetasteten Bereiche die Bereiche, beispielsweise durch die Zuordnung bestimmter Merkmale des Objekts in den Abbildungen, leichter einer Position in einem Koordinatensystem oder zueinander zuordenbar sind, wodurch insbesondere das Zusammenfügen der Abbildungen zu einer Gesamtabbildung vereinfacht wird.

Die optischen Achsen der mindestens einen ersten Kamera und der mindestens einen zweiten Kamera stehen vorzugsweise senkrecht auf einer den Kameras zugewandten Oberfläche des Objekts.

Die Bauelemente oder Baugruppen sind in oder an dem Objekt auf der den Kameras zugewandten Oberfläche des Objekts angeordnet. Bauelemente können beispielsweise Leiterbahnen oder SMD-Bauteile, aber auch Bohrlöcher, Klebepunkte, Lötstellen, Kontaktflächen oder andere auf Leiterplatten, Wafern oder Chips vorhandene Strukturen sein. Mehrere Bauelemente können zu einer Baugruppe zusammengefasst sein.

Die Auswerte- und Speichereinheit ist dazu ausgelegt, eine Prüffunktion auf die Abbildungen anzuwenden. Dabei wird ein Soll-Ist-Vergleich aller zu prüfenden Eigenschaften der Bauelemente oder Baugruppen durchgeführt. Eigenschaften der Bauelemente oder Baugruppen können beispielsweise ein Vorhandensein der Bauelemente oder Baugruppen oder eine Dimensionierung der Bauelemente oder Baugruppen sein. Die Soll-Eigenschaften der Bauelemente oder Baugruppen können dabei in einer Datenbank, die Bestandteil der Auswerte- und Speichereinheit ist, abgelegt sein. Bei dem Soll-Ist-Vergleich wird vorzugsweise ein ebenfalls in der Datenbank abgelegter Schwellwert vorgegeben und ein Bauelement und/oder eine Baugruppe nur dann als fehlerhaft erkannt, wenn der Schwellwert überschritten wird. Der Schwellwert kann beispielsweise für eine Dimensionierung der Bauteile oder Baugruppen vorgegeben werden.

Vorteilhaft weist die Kameraanordnung genau eine erste Kamera auf und die erste Auflösung der einen ersten Kamera ist höher als die zweite Auflösung der mindestens einen zweiten Kamera. Alternativ ist die zweite Auflösung höher als die erste Auflösung.

Die Vorrichtung zur AOI-Prüfung von zwei- oder dreidimensionalen Objekten kann Projektoren umfassen, die dazu ausgebildet sind, ein Muster auf das Objekt zu projizieren. Das ist insbesondere dann vorteilhaft, wenn dreidimensionale Abbildungen eines dreidimensionalen Objekts aufgenommen werden sollen. Durch die Projektion regelmäßiger Muster, beispielsweise gitterförmiger Linien auf das Objekt kann, wenn das projizierte Muster bekannt ist, aus den Abbildungen auf eine dreidimensionale Form des Objekts geschlossen werden.

Die Kameraanordnung kann zusätzlich mindestens eine Seitenkamera umfassen, die entlang einer zweiten optischen Achse ausgerichtet ist. Die zweite optische Achse schließt einen Neigungswinkel mit einer der ersten optischen Achsen ein. Dadurch kann eine Genauigkeit bei dem Erkennen fehlerhafter Bauteile erhöht werden. Zudem können so auch Bauelemente und Baugruppen erfasst werden, die Bereiche aufweisen, die von der mindestens einen ersten Kamera und/oder der mindestens einen zweiten Kamera nicht erfasst werden können. Die Bereiche können beispielsweise durch die Bauelemente oder Baugruppen aus Sicht der mindestens einen ersten Kamera und der mindestens einen zweiten Kamera verdeckt sein.

Vorzugsweise ist die Kameraanordnung zur schnelleren Aufnahme von Abbildungen der Bereiche des Objekts um eine Drehachse, die parallel zu den ersten optischen Achsen verläuft, um einen definierten Drehwinkel drehbar. Das ist insbesondere dann vorteilhaft, wenn zur beschleunigten Aufnahme der Bereiche mit höherer Auflösung Drehungen der Kameraanordnung notwendig sind. Besonders bevorzugt sind Drehwinkel von 90°, 180° und 270°, wenn in kartesischen Koordinatensystemen gemessen wird. Das schließt aber andere definierte Drehwinkel nicht aus.

Vorzugsweise umfasst die Vorrichtung Beleuchtungseinrichtungen, die dazu ausgebildet sind, die Gesamtfläche des Objekts homogen zu beleuchten. Durch eine definierte und homogene Beleuchtung kann die Genauigkeit bei dem Erkennen fehlerhafter Bauteile weiter erhöht werden.

Die Auswerte- und Speichereinheit kann dazu ausgelegt sein, die Abbildungen der Bereiche zu mindestens einer Gesamtabbildung zusammenzufügen. In diesem Fall kann die Auswerte- und Speichereinheit so ausgebildet sein, dass auch auf die Gesamtabbildung eine Prüffunktion angewendet wird.

Vorteilhaft weist die mindestens eine erste Kamera für die Prüfung von Leiterplatten eine erste physikalische Auflösung von 100 Pixel/mm bis 1.000 Pixel/mm auf und die zweite Kamera eine zweite physikalische Auflösung von 50 Pixel/mm bis 100 Pixel/mm auf oder für die Prüfung von Wafern weist die erste Kamera eine erste physikalische Auflösung von 1.000 Pixel/mm bis 10.000 Pixel/mm und die zweite Kamera eine zweite physikalische Auflösung von 100 Pixel/mm bis 1.000 Pixel/mm auf. Erste und zweite physikalische Auflösungen können sich auch um bis zu zwei Größenordnungen voneinander unterscheiden.

Die Aufgabe wird weiterhin durch ein Verfahren zur AOI-Prüfung zwei- oder dreidimensionaler Objekte mit unterschiedlichen Bereichen von zu prüfenden Bauelementen oder Baugruppen gelöst, umfassend die Schritte:
- Bereitstellen eines zwei- oder dreidimensionalen Objekts,
- Konfigurieren einer Kameraanordnung, die mindestens eine erste Kamera mit einer ersten Auflösung und mindestens eine zweite Kamera mit einer zweiten, von der ersten verschiedenen, Auflösung umfasst, wobei die mindestens eine erste Kamera und die mindestens eine zweite Kamera so angeordnet werden, dass erste optische Achsen der mindestens einen ersten Kamera und der mindestens einen zweiten Kamera parallel zueinander verlaufen und Bereiche des Objekts mit jeweils gleich großen Bildfeldern der mindestens einen ersten Kameras und der mindestens einen zweiten Kameras aufgenommen werden, wobei die Bereiche jeweils kleiner als eine abzutastende Gesamtfläche des Objekts sind,
- Aufnehmen einer Folge von Abbildungen aller Bereiche der Gesamtfläche des Objekts durch eine Relativbewegung zwischen dem Objekt und der Kameraanordnung, wobei die Gesamtheit der Bereiche wenigstens entweder von der mindestens einen ersten Kamera mit der ersten Auflösung oder von der mindestens einen zweiten Kamera mit der zweiten Auflösung, die niedriger als die erste Auflösung ist, abgetastet werden, und
- Anwenden einer Prüffunktion auf die Abbildungen der Bereiche, wobei ein Soll-Ist-Vergleich aller zu prüfenden Eigenschaften von Bauelementen oder Baugruppen des Objekts erfolgt, sodass fehlende oder fehlerhafte Bauelemente oder Baugruppen des Objekts erkannt werden.

Da zur Aufnahme der Abbildungen Kameras mit unterschiedlichen Auflösungen verwendet werden, können Bereiche des Objekts, für die eine Abbildung in einer niedrigeren Auflösung ausreicht, durch die mindestens eine zweite Kamera und Bereiche, für die eine höhere Auflösung der Abbildung benötigt wird, durch die mindestens eine erste Kamera aufgenommen werden. So kann die Gesamtfläche des Objekts mit einer vergleichsweise kostengünstigen Kameraanordnung in sehr kurzer Zeit vollständig abgebildet werden.

Das Konfigurieren der Kameraanordnung umfasst insbesondere das Kalibrieren der Fokuslagen der Kameras der Kameraanordnung. Da die die mindestens eine erste Kamera und die mindestens eine zweite Kamera so angeordnet werden, dass erste optische Achsen der mindestens einen ersten Kamera und der mindestens einen zweiten Kamera parallel zueinander verlaufen, sind auch Fokusebenen der mindestens einen ersten Kamera und der mindestens einen zweiten Kamera parallel zueinander ausgerichtet.

Um die Bereiche des Objekts abzutasten, kann entweder die Kameraanordnung oder das Objekt bewegt werden. Erfindungsgemäß werden Bereiche, die eine höhere Auflösung bei der Abtastung erfordern, zumindest durch die erste Kamera abgebildet und Bereiche, die keine höhere Auflösung bei der Abtastung erfordern, durch die zweite Kamera und/oder durch die erste Kamera abgebildet. Welche Bereiche eine höhere Auflösung bei der Abtastung erfordern, wird vorzugsweise vor der Abtastung festgelegt und ist im Wesentlichen von den in den Bereichen vorhandenen Bauelementen und/oder Baugruppen abhängig. Die Information darüber, welche Bereiche eine höhere Auflösung erfordern, kann in einer Datenbank abgelegt sein.

Die Prüffunktion wird auf alle abgebildeten Bereiche angewendet. Vorzugsweise wird die Prüffunktion nur auf die mit der ersten Auflösung abgebildeten Bereiche angewendet. Für den Soll-Ist-Vergleich können vor der Abtastung Soll-Eigenschaften der Bauelemente oder Baugruppen vorgegeben und in der Datenbank abgelegt werden. Außerdem kann für den Soll-Ist-Vergleich ein Schwellwert vorgegeben werden, der ebenfalls in der Datenbank abgelegt sein kann. Wenn eine Ist-Eigenschaft den vorgegebenen Schwellwert für eine Soll-Eigenschaft überschreitet, wird das betreffende Bauteil bzw. die betreffende Baugruppe dann als fehlerhaft erkannt.

Die Aufgabe wird zudem durch ein weiteres Verfahren zur AOI-Prüfung zwei- oder dreidimensionaler Objekte gelöst, umfassend die Schritte:
- Bereitstellen eines zwei- oder dreidimensionalen Objekts,
- Konfigurieren einer Kameraanordnung, die mindestens eine erste Kamera mit einer ersten Auflösung und mindestens eine zweite Kamera mit einer zweiten, von der ersten verschiedenen, Auflösung umfasst, wobei die mindestens eine erste Kamera und die mindestens eine zweite Kamera so angeordnet werden, dass erste optische Achsen der mindestens einen ersten Kamera und der mindestens einen zweiten Kamera parallel zueinander verlaufen und ein Bildfeld der mindestens einen ersten Kamera und der mindestens einen zweiten Kamera kleiner als eine abzutastende Gesamtfläche A des Objekts ist,
- Aufnehmen einer Folge von Abbildungen aller Bereiche der abzutastenden Gesamtfläche des Objekts durch eine Relativbewegung zwischen dem Objekt und der mindestens einen zweiten Kamera mit der zweiten Auflösung, die niedriger als die erste Auflösung ist,

- Aufnehmen von Bereichen, bei deren Aufnahme die höhere erste Auflösung erforderlich ist, durch eine Relativbewegung zwischen dem Objekt und der ersten Kamera, wobei die mindestens eine erste Kamera mit der Relativbewegung der mindestens einen zweiten Kamera mitbewegt wird und nur solche Bereiche aufnimmt, in denen die höhere erste Auflösung erforderlich ist,
- Aufnehmen von weiteren Abbildungen, falls bei der Abtastung des Objekts eine dreidimensionale Bildauswertung erforderlich ist, wenigstens in definierten Bereichen des Objekts entweder mittels der ersten und zweiten Kameras, bei einer Projektion von Mustern oder Folgen von Mustern mittels mindestens eines Projektors oder mittels mindestens einer Seitenkamera, die entlang einer zweiten optische Achse, die von den ersten optischen Achsen um einen vorgegebenen Neigungswinkel abweicht, auf das Objekt gerichtet ist,
- Berechnen mindestens einer Gesamtabbildung aus den Abbildungen der Bereiche mit einer Auswerte- und Speichereinheit die mit jeder der mindestens einen ersten und mindestens einen zweiten Kameras, und dem mindestens einen Projektor oder der mindestens einen Seitenkamera verbunden ist, wobei die Gesamtabbildung als eine zwei- oder dreidimensionale Abbildung berechnet wird, und
- Anwenden einer Prüffunktion auf die Bereiche der Gesamtabbildung, wobei ein Soll-Ist-Vergleich aller zu prüfenden Eigenschaften von Bauelementen oder Baugruppen des Objekts erfolgt, sodass fehlende oder fehlerhafte Bauelemente oder Baugruppen des Objekts erkannt werden.

Durch das Verfahren ist es möglich, sowohl drei- als auch zweidimensionale Objekte mit einer vergleichsweise kostengünstigen Kameraanordnung in sehr kurzer Zeit vollständig abzubilden und zu prüfen.

Die Gesamtabbildung beinhaltet alle Informationen der Abbildungen der einzelnen Bereiche des Objekts. Um die Gesamtabbildung zu berechnen werden die Abbildungen der Bereiche einander oder einer Position in einem Koordinatensystem zugeordnet und aus den Einzelnen Abbildungen die Gesamtabbildung zusammengesetzt.

Wenn fehlerhafte oder fehlende Bauelemente oder Baugruppen erkannt werden, kann ein Signal gesendet werden, um einen Nutzer darauf hinzuweisen. Alternativ oder zusätzlich können fehlerhafte oder fehlende Bauelemente oder Baugruppen in den Abbildungen oder in einer Gesamtabbildung markiert werden.

Die zu prüfenden Eigenschaften des Objekts können beispielsweise die Anwesenheit und/oder die Position von Lötstellen, Bauelementen in oder an Baugruppen oder von Baugruppen an oder auf dem Objekt umfassen.

Während der Abtastung der Bereiche des Objekts kann ein Muster oder eine Folge von Mustern mittels Projektoren auf das Objekt projiziert werden, um dreidimensionale Abbildungen der Bereiche zu berechnen. Die Berechnung dreidimensionaler Abbildungen kann während oder nach der Abtastung der Bereiche erfolgen.

Das Objekt wird vorzugsweise vor oder während der Abtastung der Bereiche mittels Beleuchtungseinrichtungen beleuchtet. Die Beleuchtung kann während der gesamten Abtastung oder nur abschnittsweise erfolgen. Wenn das Objekt vor der Abtastung der Bereiche mittels der Beleuchtungseinrichtungen beleuchtet wird, werden Fluoreszenz- oder Lumineszenzeigenschaften der Bauelemente oder Baugruppen ausgenutzt, um das Objekt zu prüfen.

Die Kameraanordnung kann zwischen den Aufnahmen der Abbildungen der Bereiche Bᵢ um einen Drehwinkel, der 90°, 180° oder 270° betragen kann, um eine Drehachse, die parallel zu den ersten optischen Achsen verläuft, gedreht werden. Dadurch kann flexibler ausgewählt werden, welche Bereiche hochauflösend aufgenommen werden und welche nicht und es ist höher möglich, Verfahrwege zu definieren, bei denen keine redundanten Abbildungen, also solche von Bereichen, die bereits aufgenommen worden sind, aufgenommen werden.

Vorzugsweise werden Verfahrwege und Drehungen der Kameraanordnung während der Aufnahme der Abbildungen der Bereiche in Abhängigkeit davon vorgegeben, welche Verfahrwege oder Drehungen der mindestens einen ersten Kamera und/oder der mindestens einen zweiten Kamera für das zeitoptimierte Aufnehmen aller einzelnen Bereiche mit der höheren und/oder der niedrigeren Auflösung benötigt werden. Dadurch kann gewährleistet werden, dass eine für die Aufnahme der Abbildungen der Bereiche benötigte Zeit minimiert wird.

Die Erfindung soll nachfolgend durch Ausführungsbeispiele anhand von Zeichnungen näher beschrieben werden. Hierzu zeigen:
- Fig. 1: Eine Seitenansicht einer ersten Ausführung einer Vorrichtung zur AOI-Prüfung von zwei- oder dreidimensionalen Objekten,
- Fig. 2: eine Seitenansicht einer zweiten Ausführung einer Vorrichtung zur AOI-Prüfung von zwei- oder dreidimensionalen Objekten mit Projektoren,
- Fig. 3: eine Seitenansicht einer dritten Ausführung einer Vorrichtung zur AOI-Prüfung von zwei- oder dreidimensionalen Objekten mit einer Seitenkamera und einer Beleuchtungseinrichtung,
- Fig. 4A: eine Draufsicht auf eine erste Variante der Konfiguration der Kameraanordnung mit einer ersten Kamera und einer zweiten Kamera,
- Fig. 4B: eine Draufsicht auf eine zweite Variante der Konfiguration der Kameraanordnung mit zwei ersten Kameras und zwei zweiten Kameras,
- Fig. 4C: eine Draufsicht auf eine dritte Variante der Konfiguration der Kameraanordnung mit einer ersten Kamera und drei zweiten Kameras,
- Fig. 5A: eine perspektivische Ansicht einer vierten Ausführung einer Vorrichtung zur AOI-Prüfung von zwei- oder dreidimensionalen Objekten unter Verwendung der zweiten Variante der Konfiguration der Kameraanordnung gemäß Fig. B,
- Fig. 5B: eine perspektivische Ansicht einer fünften Ausführung einer Vorrichtung zur AOI-Prüfung von zwei- oder dreidimensionalen Objekten unter Verwendung der dritten Variante der Konfiguration der Kameraanordnung gemäß Fig. 4C ,
- Fig. 5C: eine perspektivische Ansicht der fünften Ausführung der Vorrichtung zur AOI-Prüfung gemäß Fig. 5B nach einer 180°-Drehung und Verschiebung der Kameraanordnung, und
- Fig. 6: eine Ansicht einer sechsten Ausführung einer Vorrichtung zur AOI-Prüfung von auf einem Förderband angeordneten zwei- oder dreidimensionalen Objekten.

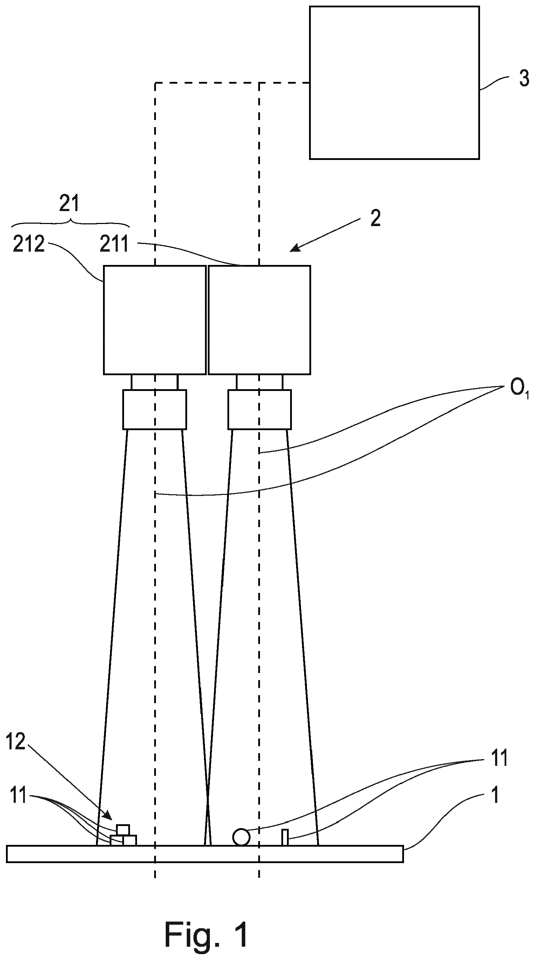

Eine erste Ausführung einer Vorrichtung zur AOI-Prüfung von zwei- oder dreidimensionalen Objekten 1 mit unterschiedlichen Bereichen von zu prüfenden Bauelementen 11 oder Baugruppen 12, insbesondere von Leiterplatten, Wafern oder Chips ist in **Fig. 1** gezeigt. Die Vorrichtung umfasst eine Kameraanordnung 2 mit mehreren Kameras mit entozentrischen Objektiv 21. Die Bauelemente 11 oder Baugruppen 12 sind auf einer den Kameras 21 zugewandte Oberfläche des Objekts 1 angeordnet. Die Kameraanordnung 2 weist bei der ersten Ausführung eine erste Kamera 211 mit einer ersten Auflösung sowie eine zweite Kamera 212 mit einer zweiten Auflösung auf. Sowohl die erste Kamera 211 als auch die zweite Kamera 212 weisen ein Objektiv auf, durch welches ein Bildfeld der ersten Kamera 211 bzw. der zweiten Kamera 212 abgebildet werden kann. Die erste Auflösung ist höher als die zweite Auflösung.

Für die Prüfung von Leiterplatten weist die erste Kamera 211 eine erste physikalische Auflösung von vorteilhaft 100 Pixel/mm bis 1.000 Pixel/mm auf und die zweite Kamera 212 eine zweite physikalische Auflösung von vorzugsweise 50 Pixel/mm bis 100 Pixel/mm auf. Für die Prüfung von Wafern weist die erste Kamera 211 eine erste physikalische Auflösung von vorzugsweise 1.000 Pixel/mm bis 10.000 Pixel/mm auf und die zweite Kamera 212 eine zweite physikalische Auflösung von vorteilhaft 100 Pixel/mm bis 1.000 Pixel/mm auf. Die erste Kamera 211 kann bevorzugt zwischen 15 und 50 Megapixel und die zweite Kamera 212 vorzugsweise zwischen 1 und 15 Megapixel aufweisen.

Erste optische Achsen O₁ der Kameras 21 verlaufen parallel zueinander. Die Kameras 21 sind dazu ausgebildet, Bereiche Bᵢ des zu prüfenden Objekts 1 in jeweils einem unterschiedlichen Bildfeld abzubilden, wobei das Bildfeld jeder der Kameras 21 kleiner als eine abzutastende Gesamtfläche A des Objekts 1 ist. Das Bildfeld der ersten Kamera 211 weist die gleiche Größe wie das Bildfeld der zweiten Kamera 212 auf. Im Bildfeld der ersten Kamera 211 sind zwei Bauelemente 11 angeordnet und im Bildfeld der zweiten Kamera 212 ist eine Baugruppe 12, bestehend aus drei Bauelementen 11, angeordnet. Die Bildfelder aller Kameras 21 überlappen sich in einer vorteilhaften Ausführung, wodurch das Zusammenfügen der einzelnen Abbildungen zu einer Gesamtabbildung vereinfacht wird.

Die Vorrichtung umfasst weiterhin eine Auswerte- und Speichereinheit 3, die mit den Kameras 21 verbunden und dazu ausgebildet ist, von den Kameras 21 aufgenommene Abbildungen zu speichern und auszuwerten. Die Verbindung der Auswerte- und Speichereinheit 3 mit den Kameras 21 ist durch gestrichelte Linien dargestellt. Die Verbindung kann jeweils durch ein Datenkabel oder kabellos, beispielsweise über WLAN oder Bluetooth, erfolgen. Die Auswerte- und Speichereinheit 3 ist dazu eingerichtet, eine Prüffunktion auf die Abbildungen von abgetasteten Bereichen Bᵢ der Gesamtfläche A des Objekts 1 anzuwenden, wobei ein Soll-Ist-Vergleich aller zu prüfenden Eigenschaften von Bauelementen 11 oder Baugruppen 12 des Objekts 1 vorgenommen werden kann, sodass fehlende oder fehlerhafte Bauelemente 11 oder Baugruppen 12 des Objekts 1 erkannt werden. Die Auswerte- und Speichereinheit 3 kann außerdem dazu eingerichtet sein, die Abbildungen der Bereiche Bᵢ zu mindestens einer Gesamtabbildung zusammenzufügen.

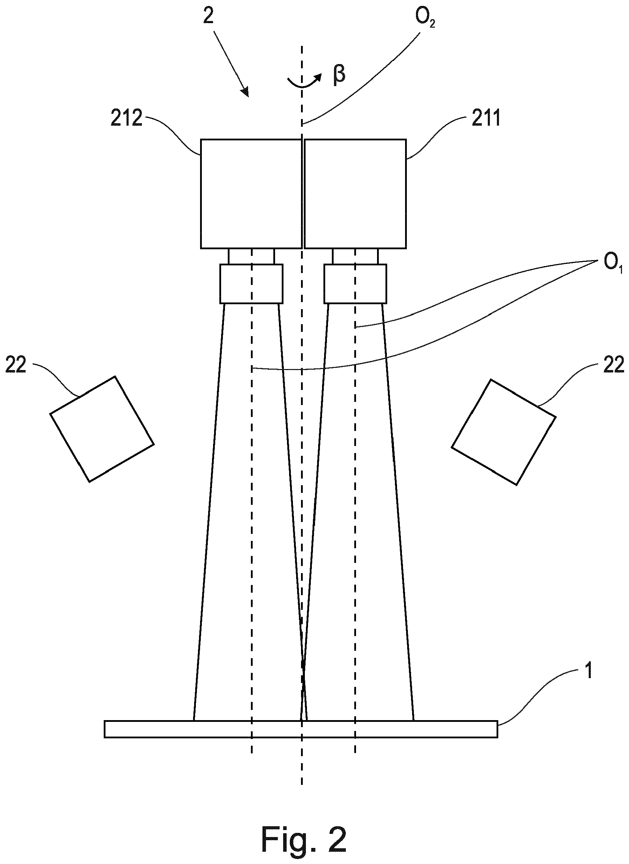

Eine zweite Ausführung der Vorrichtung zur AOI-Prüfung von zwei- oder dreidimensionalen Objekten 1 ist in **Fig. 2** dargestellt. Die zweite Ausführung der Vorrichtung umfasst Projektoren 22, die dazu ausgebildet sind, ein Muster auf das Objekt 1 zu projizieren. Die Kameraanordnung 2 ist um einen Drehwinkel β, der 0°, 90°,180° oder 270° betragen kann, um eine Drehachse D, die parallel zu den ersten optischen Achsen O₁ verläuft, drehbar.

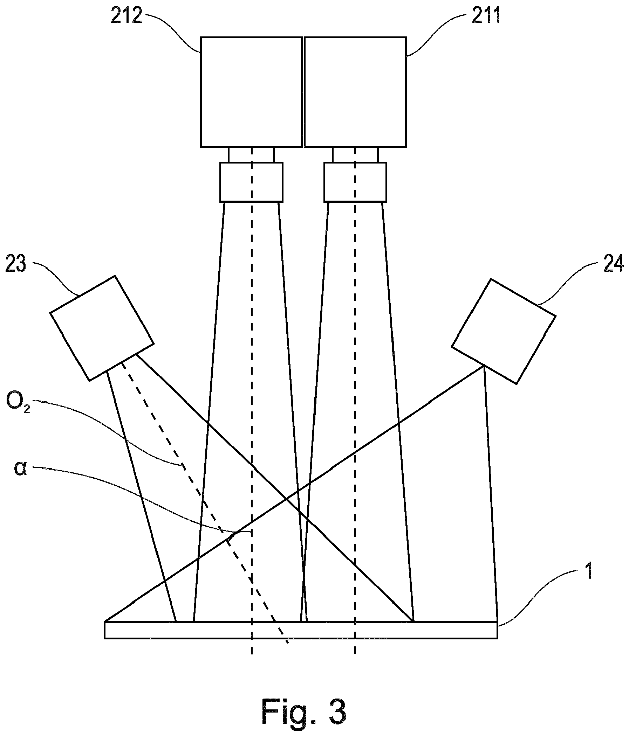

Eine dritte Ausführung der Vorrichtung zur AOI-Prüfung von zwei- oder dreidimensionalen Objekten 1 ist in **Fig. 3** abgebildet. Bei der dritten Ausführung umfasst die Kameraanordnung 2 eine Seitenkamera 23, die entlang einer zweiten optischen Achse O₂ ausgerichtet ist. Die zweite optische Achse O₂ schließt einen Neigungswinkel α mit einer der ersten optischen Achsen O₁ ein. Die dritte Ausführung der Vorrichtung umfasst darüber hinaus eine Beleuchtungseinrichtung 24, die dazu ausgebildet ist, die Gesamtfläche A des Objekts 1 homogen zu beleuchten. Die Beleuchtung kann vor oder während der Aufnahme der Abbildungen stattfinden. Sinnvollerweise findet die Beleuchtung nur dann vor der Aufnahme der Abbildungen statt, wenn zum Abbilden bzw. zum Prüfen Fluoreszenz- oder Lumineszenzeigenschaften der Bauelemente 11 oder der Baugruppen 12 ausgenutzt werden sollen.

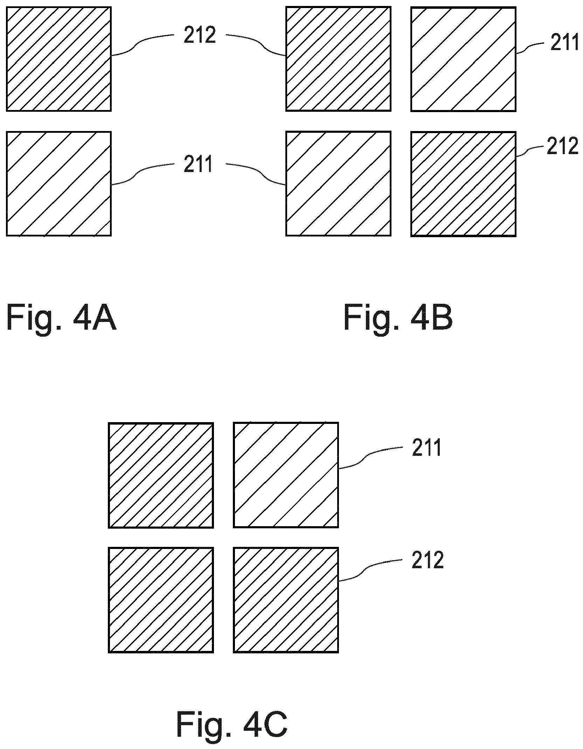

Unterschiedliche Varianten der Anordnung erster Kameras 211 und zweiter Kameras 212 zeigen die **Fig. 4A-4C****.**

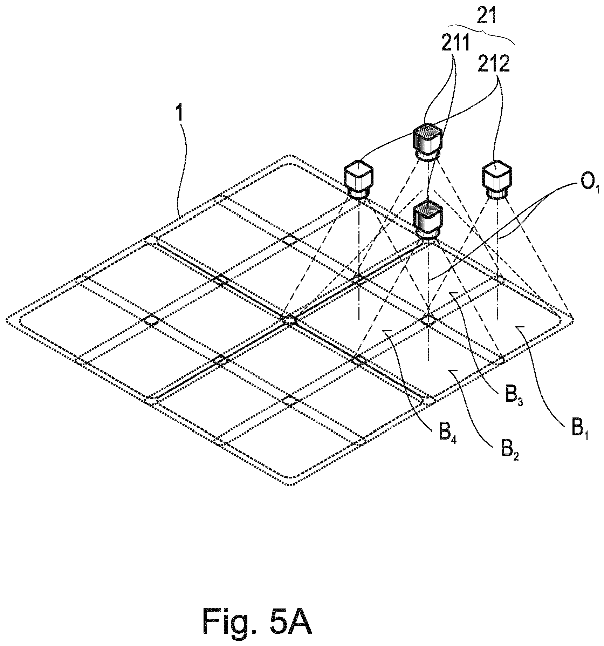

Bei der in **Fig. 4A** dargestellten ersten Variante weist die Kameraanordnung 2 genau eine erste Kamera 211 und genau eine zweite Kamera 212 auf, die in einem Raster so angeordnet sind, dass ihre gleichgroßen Bildfelder ein Rechteck abgetasteter Bereiche B₁ und B₂ auf dem Objekt 1 mit einer streifenförmigen Überlappung der Bereiche B₁ und B₂ (nur in Fig. 5A gezeigt für Variante von Fig. 4B) ergeben. Die Bereiche B₁ und B₂ können auf unterschiedliche Art und Weise abgetastet werden. Dazu können Verfahrwege und Drehungen der Kameraanordnung 2 während der Aufnahme der Abbildungen der Bereiche Bᵢ in Abhängigkeit davon vorgegeben werden, welche Verfahrwege oder Drehungen für das zeitoptimierte Aufnehmen aller einzelnen Bereiche Bᵢ mit der höheren und/oder der niedrigeren Auflösung benötigt werden. In Abhängigkeit von der zur Abbildung der Bereiche Bᵢ benötigten Auflösung können unterschiedliche Abtastmodi und/oder Verfahrwege für die erste Kamera 211 und die zweite Kamera 212 vorgegeben werden. Wenn Abbildungen der Bereiche Bᵢ nur in der ersten Auflösung oder nur der zweiten Auflösung benötigt werden, genügt es in der Regel, die Kameraanordnung 2 zur Abbildung der Bereiche Bᵢ schrittweise zu verfahren, ohne sie zu drehen, um eine lückenlose Abbildung der Gesamtfläche A des Objekts 1 zu erhalten. Wenn einzelne gewünschte oder alle Bereiche Bᵢ sowohl in der ersten Auflösung als auch in der zweiten Auflösung abgebildet werden sollen, kann die Kameraanordnung 2 entweder linear verschoben und gedreht werden, um alle gewünschten Bereiche Bᵢ mit der ersten Kamera 211 und der zweiten Kamera 212 abzubilden, oder die Kameraanordnung 2 kann über einen Rand der Bereiche Bᵢ hinaus verfahren werden, wobei dann - je nach Abtastmuster - nur entweder die erste Kamera 211 oder die zweite Kamera 212 für die noch fehlende Abbildung mit erster oder zweiter Auflösung in einem der Bereiche Bᵢ ausgelesen werden muss.

Bei der zweiten Variante der Anordnung, die **Fig. 4B** zeigt, weist die Kameraanordnung 2 zwei erste Kameras 211 und zwei zweite Kameras 212 auf, die in einem quadratischen Raster angeordnet sind. Die ersten Kameras 211 und die zweiten Kameras 212 sind dabei jeweils diagonal gegenüberliegend angeordnet. Dadurch ergibt sich ein Quadrat abgetasteter Bereiche B₁ bis B₄ auf dem Objekt 1 mit vier streifenförmigen Überlappungen der Bereiche Bᵢ, wie in Fig. 5A gezeichnet. Die Konfiguration aus diagonal gekreuzten Bereichen B₁ und B₃ mit niedriger und B₂ und B₄ mit höherer Auflösung eröffnet mit unterschiedlichen Verfahrwegen eine schnelle Abtastung des Objekts 1, wenn unterschiedlich hohe Auflösungen in verschiedenen abgetasteter Bereiche Bᵢ benötigt werden.

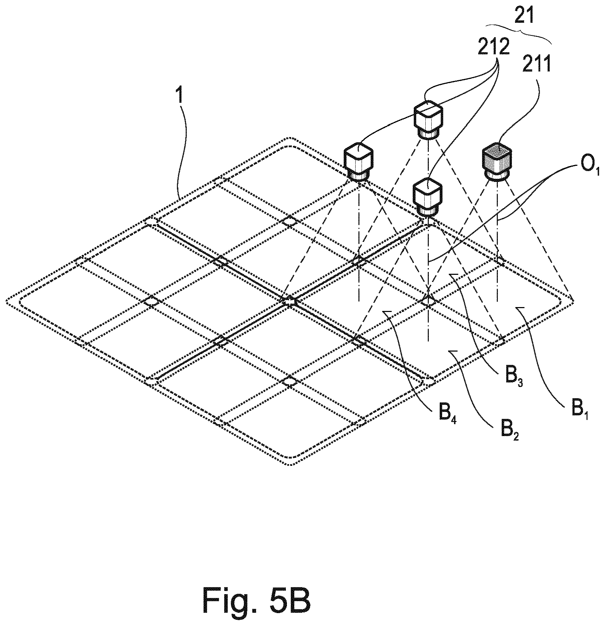

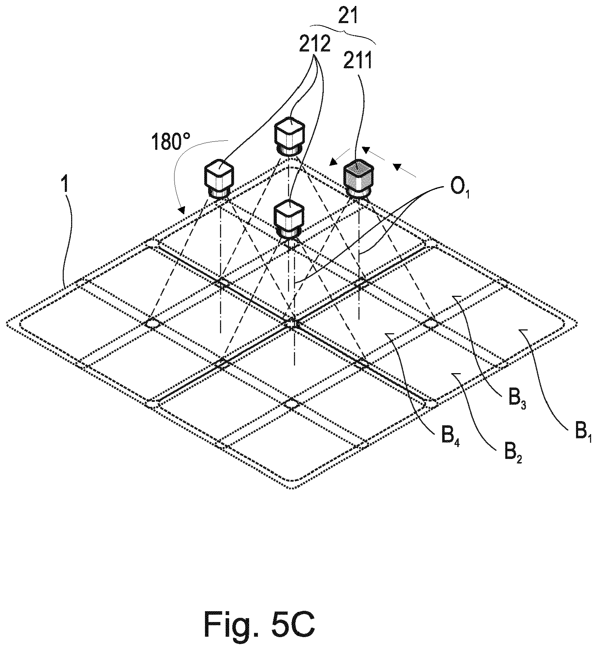

Wenn die Kameraanordnung 2 um einen Bereich Bᵢ (d.h. um die Länge bzw. Breite eines Bereichs Bᵢ) verschoben wird oder wenn die Kameraanordnung 2 um 90° gedreht wird, können Bereiche Bᵢ, die zuvor durch eine erste Kamera 211 abgebildet worden sind, durch eine zweite Kamera 212 abgebildet werden und Bereiche Bᵢ, die zuvor durch eine zweite Kamera 212 abgebildet worden sind, durch eine erste Kamera 211 abgebildet werden. Die abzubildenden Bereiche Bᵢ des Objekts 1 sind in Fig. 5A-5C schematisch dargestellt. So können alle oder die gewünschten Bereiche Bᵢ des zwei- oder dreidimensionalen Objekts 1 mit der Kameraanordnung 2 in sehr kurzer Zeit mit der ersten und der zweiten Auflösung abgebildet werden. Die vier in Fig. 5 dargestellten, von der Kameraanordnung 2 aktuell aufgenommenen benachbarten Bereiche B₁-B₄ können so nach nur einer einzigen Kameradrehung um 90° (bzw. 270°) jeweils mit der ersten Auflösung und der zweiten Auflösung aufgenommen werden, wofür nur eine einzige zusätzliche Aufnahme (gleichzeitige Auslesung von vier Abbildungen der zwei ersten Kameras 211 und zwei zweiten Kameras 212) der Kameraanordnung 2 erforderlich ist.

Die in Fig. 4C abgebildete dritte Variante weist eine erste Kamera 211 und drei zweite Kameras 212 auf. Um die vier benachbarten Bereiche B₁-B₄, die in Fig. 5B dargestellt sind, jeweils mit der ersten Auflösung und der zweiten Auflösung abzubilden, wären drei Drehungen der Kameraanordnung 2, jeweils um 90 Grad, notwendig, falls man ausschließlich durch Drehbewegungen die Abbildungen mit den zwei unterschiedlichen Auflösungen für ausschließlich dieses Viererfeld der benachbarten Bereiche B₁-B₄ aufnehmen will. Dadurch würden aber bei jeder Drehposition mindestens zwei redundante Abbildungen mit niedriger Auflösung erzeugt, die - weil sie in der Regel nicht verwendet werden - unnötig Zeit und Verarbeitungskapazität kosten. Deshalb ist die Konfiguration der Kameraanordnung 2 gemäß Fig. 4C insbesondere für eine Kombination von linearen Verfahrwegen (Translationen) und Drehungen der Kameraanordnung 2 auszuwählen, wenn nur für definierte abzutastende Bereiche Bᵢ des Objekts 1 eine hohe Auflösung der Abbildung durch die erste Kamera 211 erforderliche ist. Im Fall der benachbarten Bereiche B₁-B₄, wie sie in Fig. 5B als Viererfeld dargestellt sind, kann die gemäß Fig. 4C konfigurierte Kameraanordnung 2 genau dann effektiv zur zeitoptimierten Aufnahme der Gesamtabbildung genutzt werden, wenn weitere an das Viererfeld benachbarter Bereiche B₁-B₄ angrenzende Bereiche Bᵢ nicht mit hoher Auflösung durch die erste Kamera 211 aufgenommen werden müssen. Fig. 5B zeigt dazu eine fünfte Ausführung der Vorrichtung zur AOI-Prüfung unter Verwendung der dritten Variante der Kameraanordnung 2 gemäß Fig. 4C mit nur einer ersten Kamera 211 und drei zweiten Kameras 212. Fig. 5C zeigt ebenfalls die fünfte Ausführung der Vorrichtung zur AOI-Prüfung gemäß der dritten Variante der Kameraanordnung 2 It. Fig. 4C in einer anderen Aufnahmeposition.

Für die Konfiguration der Kameraanordnung 2 gemäß Fig. 4C zeigen **Fig. 5B** die Ausgangsposition für den ersten Aufnahmeschritt und **Fig. 5C** für den dritten Aufnahmeschritt, der nach zwei Positionsänderungen der Kameraanordnung 2 - einer 180°Drehung und translatorischer Verschiebung um einen Bereich Bᵢ zum Erreichen des zweiten Aufnahmeschritts (nicht gezeichnet) sowie einer 90°-Drehung und einem Verfahrweg um zwei Bereiche Bᵢ in eine Koordinatenrichtung und um einen Bereich Bᵢ in die andere Koordinatenrichtung zum Erreichen des dritten Aufnahmeschritts - in Fig. 5C dargestellt ist.

Im ersten Aufnahmeschritt, der in **Fig. 5B** gezeigt ist, werden eine hochauflösende Abbildung mittels der einzigen ersten Kamera 211 im Bereich B₁ und gleichzeitig drei niedrigauflösende Abbildungen mittels der zweiten Kameras 212 in den Bereichen B₂, B₃ und B₄ aufgenommen. Danach erfolgen eine 180°-Drehung und eine Verschiebung der Kameraanordnung 2 um einen Translationsbereich in Richtung B₄=> B₂ zum zweiten Aufnahmeschritt, in dem sowohl eine hochauflösende Abbildung des Bereichs B₂ und die niedrigauflösende Abbildung des Bereichs B₁ und gleichzeitig zwei weitere niedrig auflösende Abbildungen in zu den Bereichen B₁ und B₂ benachbarten Bereichen Bᵢ außerhalb des Viererfeldes B₁-B₄ aufgenommen werden.

Im dritten Aufnahmeschritt, der in **Fig. 5C** dargestellt ist und nach einer weiteren 180°-Drehung, einem Verfahrweg über zwei Bereiche Bᵢ in Richtung B₁ => B₃ und einem Verfahrweg um einen Bereich Bᵢ in Richtung B₃ => B₄ erfolgt, werden eine hochauflösende Abbildung des Bereichs B₄ sowie niedrigauflösende Abbildungen in drei außerhalb des Viererfeldes B₁-B₄ um den Bereich B₄ liegenden Bereichen Bᵢ aufgenommen.

Der vierte Aufnahmeschritt, der nach einer negativen 90°-Drehung (im Uhrzeigersinn) und einem Verfahrweg über zwei Bereiche Bᵢ in Richtung B₄ => B₃ erfolgt, werden eine hochauflösende Abbildung im Bereich B₃ sowie niedrigauflösende Abbildungen in drei außerhalb des Viererfeldes B₁-B₄ um den Bereich B₃ liegenden Bereichen Bᵢ aufgenommen. Somit sind die benachbarten Bereiche B₁-B₄ jeweils (nur einmal) sowohl mit niedriger als auch mit hoher Auflösung abgebildet und bereits weitere niedrigauflösende Abbildungen von acht außerhalb des Viererfeldes B₁-B₄ benachbart liegenden Bereichen Bᵢ aufgenommen. Bei dem vorstehend beschriebenen Beispiel, das die Kameraanordnung 2 gemäß Variante 4C mit der Vorgabe anwendet, dass im Viererfeld B₁-B₄ alle benachbarten Bereiche B₁-B₄ jeweils mit hoher und niedriger Auflösung aufzunehmen sind, kommt die mögliche Zeitersparnis erst durch den bereits im Umfeld um das Viererfeld B₁-B₄ aufgenommenen "Vorlauf" von Abbildungen außerhalb des Viererfeldes B₁-B₄ zum Tragen.

Generell hängt die Kombination von benötigten Drehungen und benötigten Verfahrwegen sowie die Anzahl an benötigten Schritten bzw. Aufnahmen von der Anzahl und der Konfiguration der ersten Kameras 211 und der zweiten Kameras 212 in der Kameraanordnung 2 ab. Die Konfiguration der ersten und zweiten Kameras 211 und 212 wird durch Anforderungen der Prüfaufgaben am Objekt 1 definiert und führt zu einem angepassten Festlegen der Bereiche Bᵢ, in denen Abbildungen mit hoher oder niedriger Auflösung oder beide erforderlich sind, und zum angepassten Anordnen der ersten Kameras 211 und der zweiten Kameras 212 in der Kameraanordnung 2. Dadurch kann beim Prüfen des Objekts 1 eine optimale Schrittfolge der Verfahrwege (Translation) und Drehungen bei der Aufnahme der gewünschten (erforderlichen) Abbildungen pro abzutastenden Bereich Bᵢ somit viel Zeit gespart werden.

Die Kameraanordnung 2 kann beispielsweise auch eine 2x3 Matrix von Kameras 21 oder 3x3 Matrix von Kameras 21 aufweisen. Die Vorrichtung kann dabei bis zu 50 Kameras aufweisen, wobei die Anzahl auch noch höher sein kann. Je mehr Kameras 21 die Kameraanordnung 2 aufweist, desto größer ist die aufgenommene Fläche aus gleichzeitig aufgenommenen Bereichen Bᵢ. Die Anordnung und die Anzahl der ersten Kameras 211 und der zweiten Kameras 212 kann auch in Abhängigkeit von einem zu vermessenden Objekt 1 vorgegeben werden. Für die so vorgegebene Kameraanordnung 2 kann dann ein optimaler Verfahrweg und/oder eine optimale Kombination mit Drehungen der Kameraanordnung 2 bestimmt werden, um die für die Abtastung des Objekts 1 benötigte Zeit zu minimieren.

Die vierte Ausführung der Vorrichtung zur AOI-Prüfung von zwei- oder dreidimensionalen Objekten 1 ist auch in **Fig. 5A** abgebildet. Die Kameraanordnung 2 weist hier, entsprechend der in Fig. 4B gezeigten dritten Variante, zwei erste Kameras 211 und zwei zweite Kameras 212 auf. Das Objekt 1 weist insgesamt sechzehn Bereiche Bᵢ auf, die durch die Kameras 21 abgebildet werden. Die Bereiche Bᵢ überlappen sich und jede der Kameras 21 erfasst mit ihrem Bildfeld einen der Bereiche Bᵢ vollständig. Da die Kameras 21 zu jedem Zeitpunkt nur einen Teil der abzutastenden Gesamtfläche A des Objekts 1 gleichzeitig erfassen, muss die Kameraanordnung 2 relativ zum Objekt 1 bewegt werden, um sukzessive die abzutastende Gesamtfläche A vollständig aufzunehmen und - trotz der Erfordernisse hoher Auflösung in definierten Bereichen Bᵢ des Objekts 1 - möglichst wenige redundante Abbildungen von Bereichen Bᵢ zu erzeugen, die keine hohe Auflösung erfordern.

Bei einem Verfahren zur AOI-Prüfung des Objekts 1 wird die Kameraanordnung 2 zunächst kalibriert, sodass die Bildfelder der Kameras 21 jeweils einen der Bereiche Bᵢ vollständig erfassen und ein Fokus der Kameras 21 jeweils in einer Objektebene liegt. Außerdem werden die Kameras 21 so angeordnet, dass die ersten optische Achsen O₁ der ersten Kameras 211 und der zweiten Kameras 212 parallel zueinander verlaufen. Jeder der Bereiche Bᵢ kann entweder mit der ersten Auflösung oder mit der zweiten Auflösung oder sowohl mit der ersten Auflösung als auch mit der zweiten Auflösung aufgenommen werden. Um die Bereiche Bᵢ sowohl mit der ersten Auflösung als auch mit der zweiten Auflösung aufzunehmen, kann die Kameraanordnung 2 gedreht werden und/oder in eine vorgegebene Richtung verschoben werden. Dabei kann die Kameraanordnung 2 um nur einen Bereich oder um mehrere Bereiche in gleicher oder unterschiedlicher Richtung verschoben werden. Von den Bereichen Bᵢ wird eine Folge von Abbildungen aufgenommen, bis die Gesamtfläche A ausreichend vollständig abgebildet worden ist. Anschließend wird eine Prüffunktion auf die Abbildungen der Bereiche Bᵢ angewendet und es erfolgt ein Soll-Ist-Vergleich aller zu prüfenden Eigenschaften von Bauelementen 11 oder Baugruppen 12 des Objekts 1.

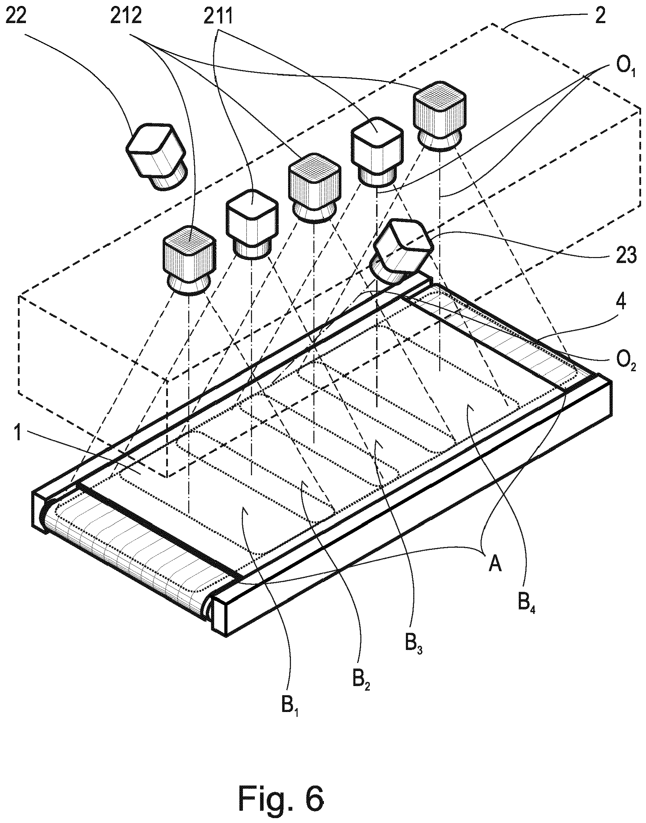

Eine sechste Ausführung der Vorrichtung zur AOI-Prüfung von zwei- oder dreidimensionalen Objekten 1 zeigt **Fig. 6****.** Die sechste Ausführung weist zwei erste Kameras 211 und drei zweite Kameras 212 auf, die alternierend auf einer Achse angeordnet sind und mit einer Seitenkamera 23 die Kameraanordnung 2 bilden. Die Vorrichtung gemäß der sechsten Ausführung weist darüber hinaus einen Projektor 22 auf. Das Objekt 1 befindet sich auf einem Förderband 4 und kann durch das Förderband 4 relativ zu der Kameraanordnung 2 bewegt werden.

Durch das Förderband 4 kann das zweidimensionale Objekt 1 bereitgestellt und eine Folge von Abbildungen aller Bereiche Bᵢ der abzutastenden Gesamtfläche A des Objekts1 durch die Relativbewegung zwischen dem Objekt 1 und der zweiten Kameras 212 mit der zweiten Auflösung, die niedriger als die erste Auflösung ist, aufgenommen werden. Anschließend oder vorzugsweise gleichzeitig können Bereiche Bᵢ, bei deren Aufnahme die höhere erste Auflösung erforderlich ist, durch die Relativbewegung zwischen dem Objekt 1 und den ersten Kameras 211, aufgenommen werden. Beispielsweise können nur die ersten beiden Bereiche B₁ und B₂ mit der ersten Auflösung und der zweiten Auflösung aufgenommen werden während die Bereiche B₃ und B₄ nur mit der zweiten Auflösung aufgenommen werden. Dazu kann die Kameraanordnung 2, falls notwendig, auch gegenüber dem Objekt 1 verdreht werden. Darüber hinaus werden weitere Abbildungen, falls bei der Abtastung des Objekts 1 eine dreidimensionale Bildauswertung erforderlich ist, wenigstens in definierten Bereichen Bᵢ des Objekts 1 aufgenommen. Die Aufnahme weiterer Abbildungen erfolgt entweder mittels der ersten Kameras 211 und zweiten Kameras 212 bei einer Projektion von Mustern oder Folgen von Mustern mittels des Projektors 22 und/oder mittels der Seitenkamera 23. Nach der Aufnahme der Abbildungen wird mindestens eine Gesamtabbildung aus den Abbildungen der Bereiche Bᵢ mit der Auswerte- und Speichereinheit 3 (nur in Fig. 1dargestellt) berechnet, wobei jede Gesamtabbildung als zwei- oder dreidimensionale Abbildung berechnet werden kann. Auf die Bereiche Bᵢ der Gesamtabbildung wird anschließend die Prüffunktion angewendet und es erfolgt ein Soll-Ist-Vergleich aller zu prüfenden Eigenschaften der Bauelemente 11 oder Baugruppen 12 (nur in Fig. 1 dargestellt) des Objekts 1, sodass fehlende oder fehlerhafte Bauelemente 11 oder Baugruppen 12 des Objekts 1 erkannt werden. Eigenschaften der Bauelemente 11 oder Baugruppen 12 können beispielsweise deren Vorhandensein, korrekte Position und/oder Dimensionierung sein.

Die zu prüfenden Eigenschaften können weiterhin die Dimensionierung, die Anwesenheit und/oder die Position von Bauelementen 11 in oder an Baugruppen 12 oder von Baugruppen 12 an oder auf dem Objekt 1 umfassen.

Während der Aufnahme der Abbildungen der Bereiche Bᵢ können Verfahrwege in Abhängigkeit davon vorgegeben werden, welche Verfahrwege oder Drehungen für das zeitoptimierte Aufnehmen aller einzelnen Bereiche Bᵢ mit der höheren und/oder der niedrigeren Auflösung benötigt werden.

### Bezugszeichenliste

- 1: Objekt
- 11: Bauelement
- 12: Baugruppen (mit Bauelementen)
- 2: Kameraanordnung
- 21: Kameras
- 211: erste Kamera
- 212: zweite Kamera
- 22: Projektor
- 23: Seitenkamera
- 24: Beleuchtungseinrichtung
- 3: Auswerte- und Speichereinheit
- 4: Förderband

- O₁: erste optische Achse
- O₂: zweite optische Achse
- A: Gesamtfläche (des Objekts)
- Bᵢ: Bereich
- B₁-B₄: (speziell abzutastendes) Viererfeld
- D: Drehachse
- α: Neigungswinkel
- β: Drehwinkel

## Patentansprüche

1. Vorrichtung zur AOI-Prüfung von zwei- oder dreidimensionalen Objekten (1) mit unterschiedlichen Bereichen (Bᵢ) von zu prüfenden Bauelementen (11) oder Baugruppen (12), insbesondere von Leiterplatten, Wafern oder Chips, umfassend:
- eine Kameraanordnung (2) mit mehreren Kameras (21), wobei
- die Kameras (21) so angeordnet sind, dass optische Achsen der Kameras (21) parallel zueinander verlaufen und
- die Kameras (21) dazu ausgebildet sind, Bereiche (Bᵢ) des zu prüfenden Objekts (1) in jeweils einem unterschiedlichen Bildfeld abzubilden, wobei das Bildfeld jeder der Kameras (21) kleiner als eine abzutastende Gesamtfläche (A) des Objekts (1) ist,
- eine Auswerte- und Speichereinheit (3), die mit den Kameras (21) verbunden und dazu ausgebildet ist, von den Kameras (21) aufgenommene Abbildungen zu speichern und auszuwerten, **dadurch gekennzeichnet, dass**
- die Kameras (21) als entozentrische Kameras ausgebildet sind,
- die Kameraanordnung (2) mindestens eine erste Kamera (211) mit einer ersten Auflösung und mindestens eine zweite Kamera (212) mit einer zweiten, von der ersten verschiedenen Auflösung aufweist, wobei die mindestens eine erste Kamera (211) und die mindestens eine zweite Kamera (212) gleich große Bildfelder und zueinander parallel ausgerichtete erste optische Achsen (O₁) aufweisen, und
- die Auswerte- und Speichereinheit (3) so eingerichtet ist, um eine Prüffunktion auf die Abbildungen von abgetasteten Bereichen (Bᵢ) der Gesamtfläche (A) des Objekts (1) anzuwenden, wobei ein Soll-Ist-Vergleich aller zu prüfenden Eigenschaften von Bauelementen (11) oder Baugruppen (12) des Objekts (1) vorhanden ist, sodass fehlende oder fehlerhafte Bauelemente (11) oder Baugruppen (12) des Objekts (1) erkannt werden.

2. Vorrichtung nach Anspruch 1, **dadurch gekennzeichnet, dass** die Kameraanordnung (2) genau eine erste Kamera (211) aufweist und die erste Auflösung der einen ersten Kamera (211) höher ist als die zweite Auflösung der mindestens einen zweiten Kamera (212).

3. Vorrichtung nach Anspruch 1 oder 2, **dadurch gekennzeichnet, dass** die Vorrichtung Projektoren (22) umfasst, die dazu ausgebildet sind, ein Muster auf das Objekt (1) zu projizieren.

4. Vorrichtung nach einem der Ansprüche 1 bis 3, **dadurch gekennzeichnet, dass** die Kameraanordnung (2) zusätzlich mindestens eine Seitenkamera (23) umfasst, die entlang einer zweiten optischen Achse (O₂) ausgerichtet ist und die zweite optische Achse (O₂) einen Neigungswinkel (α) gegenüber den ersten optischen Achsen (O₁) aufweist.

5. Vorrichtung nach einem der Ansprüche 1 bis 4, **dadurch gekennzeichnet, dass** die Kameraanordnung (2) um einen Drehwinkel (β), der 0°, 90°,180° oder 270° betragen kann, um eine Drehachse (D), die parallel zu den ersten optischen Achsen (O₁) verläuft, drehbar ist.

6. Vorrichtung nach einem der Ansprüche 1 bis 5, **dadurch gekennzeichnet, dass** die Vorrichtung Beleuchtungseinrichtungen (24) umfasst, die dazu ausgebildet sind, die Gesamtfläche (A) des Objekts (1) homogen zu beleuchten.

7. Vorrichtung nach einem der Ansprüche 1 bis 6, **dadurch gekennzeichnet, dass** die Auswerte- und Speichereinheit (3) dazu ausgelegt ist, die Abbildungen der Bereiche (Bᵢ) zu mindestens einer Gesamtabbildung zusammenzufügen.

8. Vorrichtung nach einem der Ansprüche 1 bis 6, **dadurch gekennzeichnet, dass** die mindestens eine erste Kamera (211) für die Prüfung von Leiterplatten eine erste physikalische Auflösung von 100 Pixel/mm bis 1.000 Pixel/mm aufweist und die zweite Kamera (212) eine zweite physikalische Auflösung von 50 Pixel/mm bis 100 Pixel/mm aufweist oder die erste Kamera (211) für die Prüfung von Wafern eine erste physikalische Auflösung von 1.000 Pixel/mm bis 10.000 Pixel/mm aufweist und die zweite Kamera (212) eine zweite physikalische Auflösung von 100 Pixel/mm bis 1.000 Pixel/mm aufweist.

9. Verfahren zur AOI-Prüfung zwei- oder dreidimensionaler Objekte (1) mit unterschiedlichen Bereichen (Bi) von zu prüfenden Bauelementen (11) oder Baugruppen (12), umfassend folgende Schritte:
- Bereitstellen eines zwei- oder dreidimensionalen Objekts (1),
- Konfigurieren einer Kameraanordnung (2), die mindestens eine erste Kamera (211) mit einer ersten Auflösung und mindestens eine zweite Kamera (212) mit einer zweiten, von der ersten verschiedenen, Auflösung umfasst, wobei die mindestens eine erste Kamera (211) und die mindestens eine zweite Kamera (212) so angeordnet werden, dass erste optische Achsen (O₁) der mindestens einen ersten Kamera (211) und der mindestens einen zweiten Kamera (212) parallel zueinander verlaufen und Bereiche (Bᵢ) des Objekts (1) mit jeweils gleich großen Bildfeldern der mindestens einen ersten Kamera (211) und der mindestens einen zweiten Kamera (212) aufgenommen werden, wobei die Bereiche (Bᵢ) jeweils kleiner als eine abzutastende Gesamtfläche (A) des Objekts (1) sind,
- Aufnehmen einer Folge von Abbildungen aller Bereiche (Bᵢ) der Gesamtfläche (A) des Objekts (1) durch eine Relativbewegung zwischen dem Objekt (1) und der Kameraanordnung (2), wobei die Gesamtheit der Bereiche (Bᵢ) wenigstens entweder von der mindestens einen ersten Kamera (211) mit der ersten Auflösung oder von der mindestens einen zweiten Kamera (212) mit der zweiten Auflösung, die kleiner als die erste Auflösung ist, abgetastet werden, und
- Anwenden einer Prüffunktion auf die Abbildungen der Bereiche (Bᵢ), wobei ein Soll-Ist-Vergleich aller zu prüfenden Eigenschaften von Bauelementen (11) oder Baugruppen (12) des Objekts (1) erfolgt, sodass fehlende oder fehlerhafte Bauelemente (11) oder Baugruppen (12) des Objekts (1) erkannt werden.

10. Verfahren zur AOI-Prüfung zwei- oder dreidimensionaler Objekte (1), umfassend folgende Schritte:
- Bereitstellen eines zwei- oder dreidimensionalen Objekts (1),
- Konfigurieren einer Kameraanordnung (2), die mindestens eine erste Kamera (211) mit einer ersten Auflösung und mindestens eine zweite Kamera (212) mit einer zweiten, von der ersten verschiedenen Auflösung umfasst, wobei die mindestens eine erste Kamera (211) und die mindestens eine zweite Kamera (212) so angeordnet werden, dass erste optische Achsen (O₁) der mindestens einen ersten Kamera (211) und der mindestens einen zweiten Kamera (212) parallel zueinander verlaufen und ein Bildfeld der mindestens einen ersten Kamera (211) und der mindestens einen zweiten Kamera (212) kleiner als eine abzutastende Gesamtfläche (A) des Objekts (1) ist,
- Aufnehmen einer Folge von Abbildungen aller Bereiche (Bᵢ) der abzutastenden Gesamtfläche (A) des Objekts (1) durch eine Relativbewegung zwischen dem Objekt (1) und der mindestens einen zweiten Kamera (212) mit der zweiten Auflösung, die niedriger als die erste Auflösung ist,
- Aufnehmen von Bereichen (Bᵢ), bei deren Aufnahme die höhere erste Auflösung erforderlich ist, durch eine Relativbewegung zwischen dem Objekt (1) und der ersten Kamera (211), wobei die mindestens eine erste Kamera (211) mit der Relativbewegung der mindestens einen zweiten Kamera (212) mitbewegt wird und nur solche Bereiche (Bᵢ) aufnimmt, in denen die erste Auflösung erforderlich ist,
- Aufnehmen von weiteren Abbildungen, falls bei der Abtastung des Objekts (1) eine dreidimensionale Bildauswertung erforderlich ist, wenigstens in definierten Bereichen (Bᵢ) des Objekts (1):
- entweder mittels der ersten und zweiten Kameras (211, 212) bei einer Projektion von Mustern oder Folgen von Mustern mittels mindestens eines Projektors (22)
- oder mittels mindestens einer Seitenkamera (23), die entlang einer zweiten optische Achse (O₂), die von den ersten optischen Achsen (O₁) um einen vorgegebenen Neigungswinkel (α) abweicht, auf das Objekt (1) gerichtet ist,
- Berechnen mindestens einer Gesamtabbildung aus den Abbildungen der Bereiche (Bᵢ) mit einer Auswerte- und Speichereinheit (3), die mit jeder der mindestens einen ersten und mindestens einen zweiten Kameras (211, 212) und dem mindestens einen Projektor (22) oder der mindestens einen Seitenkamera (23) verbunden ist, wobei die mindestens eine Gesamtabbildung als eine zwei- oder dreidimensionale Abbildung berechnet wird, und
- Anwenden einer Prüffunktion auf die Bereiche (Bᵢ) der mindestens einen Gesamtabbildung, wobei ein Soll-Ist-Vergleich aller zu prüfenden Eigenschaften von Bauelementen (11) oder Baugruppen (12) des Objekts (1) erfolgt, sodass fehlende oder fehlerhafte Bauelemente (11) oder Baugruppen (12) erkannt werden.

11. Verfahren nach Anspruch 9 oder 10, **dadurch gekennzeichnet, dass** die zu prüfenden Eigenschaften des Objekts (1) die Anwesenheit und/oder die Position von Lötstellen, Bauelementen (11) in oder an Baugruppen (12) oder von Baugruppen (12) an oder auf dem Objekt (1) umfassen.

12. Verfahren nach einem der Ansprüche 9 bis 11, **dadurch gekennzeichnet, dass** vor oder während der Abtastung der Bereiche (Bᵢ) ein Muster oder eine Folge von Mustern mittels Projektoren (22) auf das Objekt (1) projiziert wird, um 3D-Abbildungen der Bereiche (Bᵢ) zu berechnen.

13. Verfahren nach einem der Ansprüche 9 bis 12, **dadurch gekennzeichnet, dass** das Objekt (1) vor oder während der Abtastung der Bereiche (Bᵢ) mittels Beleuchtungseinrichtungen (24) beleuchtet wird.

14. Verfahren nach einem der Ansprüche 9 bis 13, **dadurch gekennzeichnet, dass** die Kameraanordnung (2) zwischen den Aufnahmen der Abbildungen der Bereiche (Bᵢ) um einen Drehwinkel (β), der 0°, 90°, 180° oder 270° betragen kann, um eine Drehachse (D), die parallel zu den ersten optischen Achsen (O₁) verläuft, gedreht wird.

15. Verfahren nach einem der Ansprüche 9 bis 14, **dadurch gekennzeichnet, dass** Verfahrwege und Drehungen der Kameraanordnung (2) während der Aufnahme der Abbildungen der Bereiche (Bᵢ) in Abhängigkeit davon vorgegeben werden, welche Verfahrwege oder Drehungen für das zeitoptimierte Aufnehmen aller einzelnen Bereiche (Bᵢ) mit der höheren und/oder der niedrigeren Auflösung benötigt werden.
